# FASCICULE DE BREVET EUROPEEN

(11) **EP 0 685 944 B1**
(45) Date de publication et mention de la délivrance du brevet: **01.08.2001**
(21) Numéro de dépôt: 95401249.8
(22) Date de dépôt: 30.05.1995
(51) Int. Cl.: H03M 1/30

(54) **Codeur pour mesurer les mouvements relatifs entre deux objets**
Kodierer zum Messen der Relativbewegung zwischen zwei Objekten
Encoder for measuring the relative movement between two objects

(30) Priorité: 01.06.1994 FR 9406691
(43) Date de publication de la demande: 06.12.1995
(73) Titulaire: COMMISSARIAT A L'ENERGIE ATOMIQUE, 75015 Paris (FR)
(72) Inventeur: Saro, Miguel, F-38170 Seyssinet (FR)
(74) Mandataire: Dubois-Chabert, Guy

(56) Documents cités:
- EP-A- 0 087 536
- DE-A- 4 028 792
- ELECTRONIC ENGINEERING, vol. 59, no. 731, Novembre 1987 LONDON GB, pages 37-38, PETRIU 'Improved optical shaft encoder resolution'

## Description

La présente invention a pour objet un codeur permettant de mesurer des mouvements relatifs entre deux objets.

L'invention trouve ses applications en particulier dans le domaine de la robotique (pour le déplacement des robots) ou dans le domaine de la métrologie.

### Etat de la technique

Pour mesurer des mouvements relatifs entre deux objets, il est connu d'effectuer des mesures de déplacement au moyen de codeurs. Ces codeurs qui sont le plus souvent des codeurs linéaires ou des codeurs angulaires comportent, d'une part, une règle graduée (ou bien règle de mesure, ou tout simplement règle) qui est portée par l'un des objets et, d'autre part, au moins un lecteur qui est porté par l'autre objet.

La règle graduée du codeur comporte une pluralité de pistes (ou canaux) sur lesquelles sont inscrites des graduations, appelées plus couramment marques, qui peuvent être de types divers : marques optiques, marques magnétiques, etc. Quel qu'en soit le type, ces marques sont codées sur les pistes de la règle selon un code qui peut être le code GRAY, le code JOHNSON, le code binaire pur, ou tout autre code.

D'une façon générale, les codeurs actuellement connus se divisent en deux grands groupes : les codeurs absolus et les codeurs incrémentaux. Cette division des codeurs est réalisée en fonction du type d'informations que chaque codeur est apte à délivrer :
. Un codeur absolu délivre une information qui correspond à la position du lecteur sur la règle de mesure. Aussi, chaque graduation de la règle est repérée d'une façon unique et ne peut être confondue avec aucune autre graduation. Dans ce cas, le lecteur lit le repérage sur la règle.
. Un codeur incrémental délivre une information élémentaire chaque fois que la position lecteur/règle varie d'une graduation. Aussi, toutes les graduations portent la même information et, pour reconnaître les déplacements entre le lecteur et la règle, il faut compter le nombre d'informations lues par le lecteur. Dans la pratique, l'information élémentaire est insuffisante ; aussi, les codeurs incrémentaux du commerce comportent en général au moins trois canaux d'informations, appelés également "pistes". L'une de ces pistes délivre une impulsion lors du passage du lecteur devant un point de référence de la règle, appelé "TOP ZERO". Les autres pistes permettent d'obtenir des informations relatives au déplacement et au sens de déplacement des objets.

Le document EP-A-0 087 536 décrit, par exemple, un codeur d'impulsions à zones d'aimantation inverses, dont le « top zéro » est codé sur une piste réservée uniquement à ce top zéro.

Le document DE-A-4 028 792 décrit un codeur optique comprenant une seule piste munie de marques simples et de marques spécifiques dont la taille ou la densité optique diffère de celle des marques simples, le comptage étant effectué à partir de la différence d'amplitude des signaux optiques transmis par la piste du codeur.

Un autre type de codeur incrémental est le codeur à trois pistes fabriqué et commercialisé par la Société SUNX, à Tokyo (Japon).

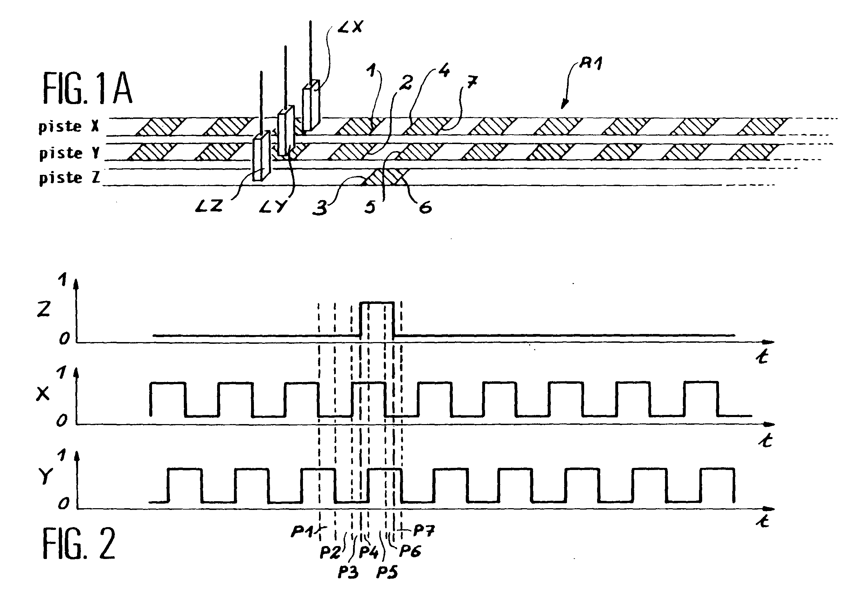

La structure théorique d'un tel codeur incrémental à trois pistes est représentée sur la figure 1A annexée. Sur cette figure 1A, on a représenté un codeur incrémental comportant trois pistes :
- une piste X et une piste Y qui contiennent différentes marques permettant d'obtenir des informations sur le déplacement et le sens du mouvement des objets ;
- une piste Z qui contient la marque du "TOP ZERO".

On a représenté aussi sur cette figure les lecteurs associés à chacune des pistes :
le lecteur LX associé à la piste X ;
le lecteur LY associé à la piste Y ;
le lecteur LZ associé à la piste Z et donc apte à détecter la marque du TOP ZERO, c'est-à-dire la marque représentative du point de référence de la règle de mesure R1.

On a référencé 1, 2, 3, 4, 5, 6 et 7, les limites des marques de chacune des pistes X, Y et Z de la règle de mesure R1. De façon plus précise, 1 est une limite de fin de marque de la piste X, 4 est une limite de début de marque de la piste X et 7 est encore une limite de fin de marque de la piste X. La référence 2 représente une limite de fin de marque de la piste Y et 5 représente une limite de début de marque de la piste Y. Parallèlement, la référence 3 et la référence 6 représentent des limites, respectivement, de début et de fin de la marque de TOP ZERO de la piste Z.

Ainsi, chaque limite de début ou de fin de marque des pistes X ou Y indique un changement de pas sur la règle de mesure R1. On comprendra donc qu'un pas est une graduation de la règle de mesure R1 et que les pas d'une règle sont fonction de l'ensemble des pistes constituant cette règle, autres que la piste de TOP ZERO.

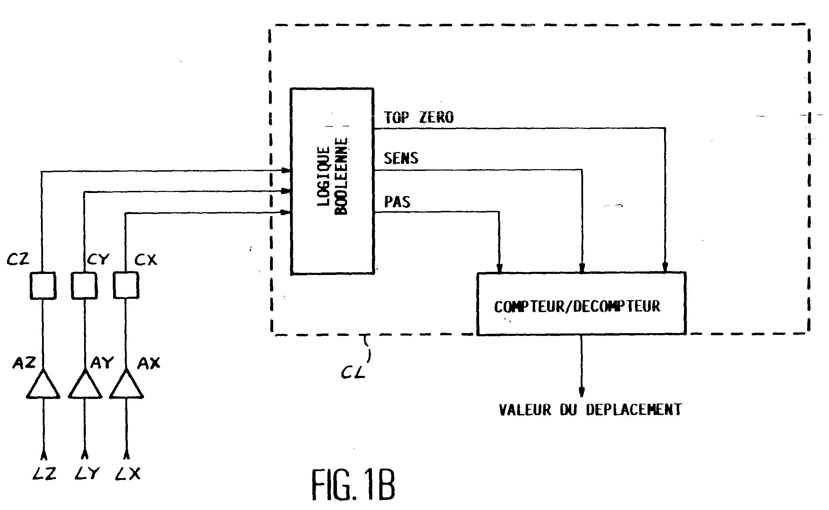

Les lecteurs LX, LY et LZ détectent donc chacune des marques sur les pistes X, Y et Z et fournissent des signaux électriques représentatifs des marques lues. Pour une meilleure exploitation de ces signaux, un amplificateur de signaux AX, AY ou AZ est connecté à la sortie de chaque lecteur (voir figure 1B). La sortie de chaque amplificateur AX, AY, AZ est elle-même connectée sur l'entrée d'un convertisseur analogique/numérique, respectivement CX, CY, CZ (nommé aussi conformateur) qui est apte à transformer les signaux électriques amplifiés en signaux logiques de niveau 0 ou 1.

Les sorties des codeurs, tels qu'on les trouvent dans le commerce, correspondent aux sorties des convertisseurs A/N. Toutefois, des moyens d'analyse peuvent être ensuite connectés sur ces sorties de convertisseurs A/N.

La figure 1B montre un exemple de ces moyens d'analyse CL des signaux issus des convertisseurs A/N. Ces moyens d'analyse CL comportent une logique booléenne qui génère, en utilisant les signaux de sortie des convertisseurs A/N, un signal TOP ZERO qui remet à zéro un compteur/décompteur, un signal SENS de déplacement qui inverse le sens de comptage du compteur/décompteur et un signal PAS qui est utilisé comme horloge de comptage/décomptage.

La valeur (en nombre de pas) du déplacement par rapport au TOP ZERO est disponible sur les sorties digitales du compteur/décompteur. Cette valeur peut être codée dans n'importe quelle base numérique (par exemple décimale, hexadécimale,...).

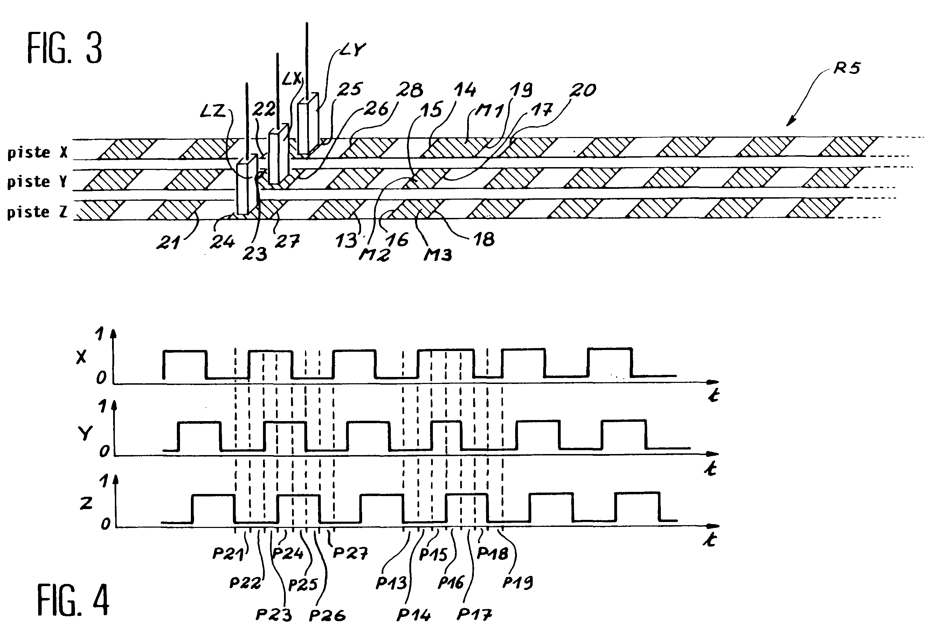

Sur la figure 2, on a représenté le diagramme temporel obtenu pour le codeur incrémental représenté sur la figure 1A, c'est-à-dire les chronogrammes obtenus pour chacune des trois pistes X, Y et Z.

Les chronogrammes Z, Y et X montrent donc chacun, les signaux obtenus dans le temps, pour chacune des pistes respectives, piste Z, piste Y et piste X. Le chronogramme Z ne comporte, comme on le voit sur cette figure 2, qu'un seul signal représentant la marque de TOP ZERO lue sur la piste Z de la figure lA par le lecteur LZ. Les chronogrammes Y et X montrent une pluralité de signaux représentatifs chacun des marques lues, respectivement, par les lecteurs LX et LY sur les pistes X et Y.

Sur cette figure 2, on a référencé P1, le pas entre la limite de marque 1 et la limite de marque 2 montrées sur la figure 1A. La référence P2 représente le pas entre la limite de marque 2 et la limite de marque 4 montrées sur cette figure 1A. Comme on le voit sur la figure 2, la référence P3 représente un demi-pas entre la limite de marque 4 de la piste X et la limite 3 de la marque de TOP ZERO sur la piste Z et la référence P4 représente le demi-pas entre la limite de marque 3 de la marque de TOP ZERO et la limite de marque 5 sur la piste Y. La limite de début de marque du TOP ZERO provoque donc des demi-pas sur la règle R1. De même, la limite de fin de marque du TOP ZERO sur la piste Z provoque des demi-pas référencés P6 et P7. Le pas P5 est défini par les limites 5 et 7.

Ces figures 1A et 2 permettent donc de montrer qu'il y a une différence de quantité d'informations très sensible entre la piste Z de TOP ZERO et les autres pistes X et Y du codeur. Les lecteurs LX et LY lisent donc une pluralité de marques répétitives, tandis que le lecteur LZ ne lit qu'une seule marque. Or, il s'avère que les lecteurs réagissent de façon différente en fonction de la densité des informations lues, donc de la quantité de marques sur une piste. En particulier, les lecteurs de type magnétique réagissent fort mal aux informations isolées de type TOP ZERO.

En outre, pour des raisons de traitement électronique, les signaux obtenus en sortie des codeurs ne doivent pas changer d'état simultanément. Ceci nécessite de positionner la marque de TOP ZERO sur des demi-pas, comme montré sur les figures 1A et 2. De ce fait, la précision du positionnement de la marque de TOP ZERO est double de la précision des autres pas.

La réalisation d'un tel codeur incrémental et donc lourde est difficile à mettre en oeuvre du fait de cette double précision du positionnement de la marque de TOP ZERO.

### Exposé de l'invention

La présente invention a justement pour but de remédier à ces inconvénients. A cette fin, elle propose un codeur permettant de mesurer des mouvements relatifs entre deux objets, codeur pour lequel les informations de changement de pas sont réparties sur toutes les pistes de la règle de mesure et pour lequel le TOP ZERO est codé avec au moins deux marques sur au moins deux pistes de la règle de mesure.

De façon plus précise, l'invention a pour objet un codeur pour mesurer des mouvements relatifs entre un premier et un second objets. Ce codeur comporte :
- une règle de mesure portée par le premier objet et comprenant au moins deux pistes munies chacune d'une pluralité de marques ;
- au moins deux lecteurs de marques portés par le second objet, chacune des pistes de la règle de mesure étant lue par au moins un lecteur de marques, celui-ci étant apte à détecter les marques de la piste à laquelle il est associé ; et
- des moyens de traitements connectés aux lecteurs de marques.

Ce codeur se caractérise par le fait que toutes les pistes comportent sensiblement un même nombre de marques, que chaque marque comprend une limite de début et une limite de fin de marque qui définissent chacune un changement de pas sur la règle de mesure et que les marques de la règle de mesure consistent en une pluralité de marques simples ayant toutes des caractéristiques sensiblement identiques et au moins deux marques spécifiques situées, respectivement, sur deux pistes distinctes de la règle de mesure et ayant chacune une caractéristique différente des caractéristiques des marques simples, ces marques spécifiques indiquant au moins une position de référence de la règle, l'ensemble des marques simples et spécifiques de toutes les pistes définissant une succession de pas réguliers le long de la règle.

Selon l'invention, les marques spécifiques ont une longueur, dans le sens de déplacement, supérieure ou inférieure à celle des marques simples, la caractéristique des marques spécifiques qui diffère de celle des marques simples étant la longueur, ce qui peut être considéré comme une modulation de largeur, appelée aussi modulation de phase.

Selon une variante de l'invention, la marque spécifique a en outre une largeur sensiblement inférieure ou supérieure à celle des marques simples.

Selon encore une autre variante de l'invention, chaque piste de la règle de mesure comporte une marque spécifique. Chacune de ces marques spécifiques a une longueur différente à la fois des marques simples et des autres marques spécifiques de la règle de mesure.

Selon encore un autre mode de réalisation de l'invention, une caractéristique qui diffère entre les marques simples et la marque spécifique peut être, en outre, la densité optique de marquage.

Une telle règle de mesure présente donc une quantité d'informations sensiblement identique sur chacune de ses pistes.

Avantageusement, les moyens de traitements comportent, pour chaque lecteur, un amplificateur et au moins un conformateur pour transformer le signal de sortie du lecteur en un signal numérique et des moyens d'analyse des signaux numériques issus des conformateurs.

Les moyens d'analyse sont, par exemple, ceux décrits en référence à la figure 1B ; ils peuvent aussi consister en un calculateur.

Le codeur de l'invention peut s'appliquer aussi bien en optique qu'en magnétisme. Il permet de diminuer le nombre de marques par piste puisque le codage est réparti sur l'ensemble des pistes. La densité d'informations étant plus faible, les lecteurs utilisés peuvent présenter une résolution plus faible et donc être d'un coût plus faible.

### Brève description des dessins

- La figure 1A, déjà décrite, représente la structure théorique d'un codeur incrémental connu, à trois pistes X, Y et Z ;
- la figure 1B, déjà décrite, représente schématiquement les moyens de traitement classiques du codeur de la figure 1A ;
- la figure 2, déjà décrite, représente le diagramme temporel du codeur incrémental représenté sur la figure 1A ;
- la figure 3 représente la structure d'un exemple de codeur à trois pistes selon l'invention ;
- la figure 4 représente le diagramme temporel obtenu pour le codeur représenté sur la figure 3 ;
- la figure 5 représente la structure d'un exemple de codeur de l'invention dont la règle de mesure comporte deux pistes à chacune desquelles sont associés deux lecteurs ;
- la figure 6 représente le diagramme temporel obtenu pour le codeur représenté sur la figure 5 ; et
- la figure 7 représente schématiquement les moyens de traitements d'un codeur selon l'invention.

### Exposé détaillé de modes de réalisations de l'invention

La figure 3 représente la structure théorique d'un exemple de codeur selon l'invention comportant trois pistes, la piste X, la piste Y et la piste Z. Chaque piste comprend une pluralité d'ondes constituées d'une marque et de l'espace non marqué suivant ladite marque. La règle R5 ayant trois pistes, chaque onde de cette règle R5 comprend 3X2 pas, soit 6 pas. Chacune de ces pistes X, Y ou Z comporte un nombre de marques sensiblement égale. Ainsi, les marques de définition des pas sont réparties sur les trois pistes de la règle de mesure R5.

A chacune de ces pistes X, Y et Z, est associé, respectivement, un lecteur LX, un lecteur LY et un lecteur LZ, tous trois aptes à détecter chacune des marques de la piste à laquelle il est associé.

Pour le mode de réalisation représenté sur cette figure 3, le TOP ZERO est réalisé au moyen de deux marques spécifiques réparties sur les deux pistes X et Y et d'une marque simple sur la piste Z de la règle de mesure R5. Comme on peut le constater sur cette figure, ces marques spécifiques sont référencées M1 pour la piste X et M2 pour la piste Y et la marque simple de la piste Z est référencée M3.

La marque spécifique M1 est plus longue qu'une marque simple ; la marque spécifique M2 est plus courte qu'une marque simple. On dit, dans ce cas, que le TOP ZERO est crypté par modulation de longueur, appelée aussi modulation de phase.

Dans un autre mode de réalisation, le TOP ZERO peut être crypté en modulant, en outre, la densité optique des marques. Ces deux modulations peuvent donc être combinées pour permettre une redondance de la lecture du TOP ZERO.

Sur cette figure 3, la référence 13 représente la limite de fin d'une marque simple de la piste Z ; la référence 15 représente la limite de début de la marque spécifique M2 de la piste Y ; la référence 14 représente la limite du début de la marque spécifique M1 de la piste X ; la référence 16 représente la limite du début de la marque simple M3 de la piste Z ; la référence 17 représente la limite de la fin de la marque M2 de la piste Y ; 18 représente la limite de fin de la marque simple M3 de la piste Z ; 19 représente la limite de fin de la marque spécifique M1 de la piste X et 20 représente la limite de début d'une marque simple de la piste X.

Les signaux analogiques obtenus en sortie des lecteurs LX, LY et LZ sont exploités avec des moyens de traitements sensiblement similaires à ceux de l'art antérieur décrit précédemment : les signaux sont tout d'abord amplifiés, puis transformés en signaux logiques par des conformateurs ; ils sont ensuite envoyés à des moyens d'analyse, tels que ceux décrits en référence à la figure 1B, ou à un calculateur.

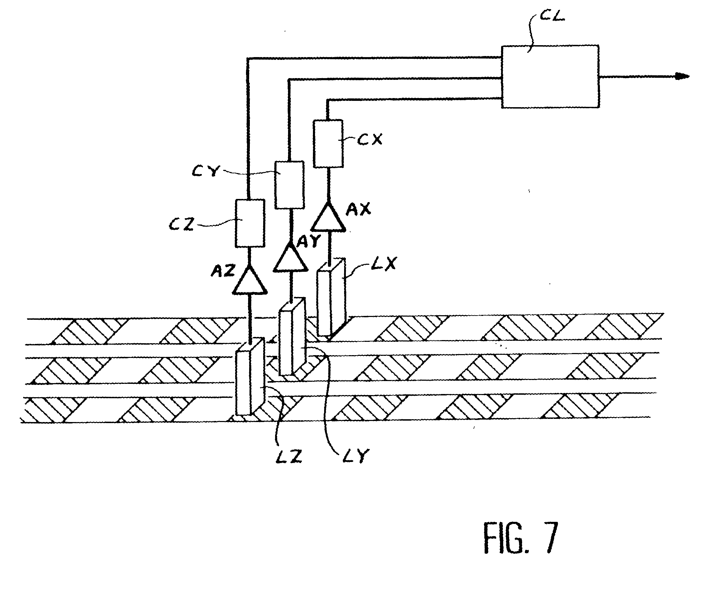

Sur la figure 7, on a justement représenté un codeur de même type que celui de la figure 3. Ce codeur comporte trois pistes X, Y et Z auxquelles sont associés respectivement les trois lecteurs LX, LY et LZ. On a représenté en outre sur cette figure 7, de façon schématique, les trois amplificateurs AX, AY et AZ suivis des trois conformateurs CX, CY et CZ. Les trois signaux logiques de sortie des conformateurs sont envoyés, comme décrit précédemment, à l'entrée de moyens d'analyses CL ou à l'entrée d'un calculateur.

Si l'on se reporte maintenant à la figure 4, on peut y voir les pas P13 à P19 correspondant aux pas réalisés par les limites de début et de fin de marques, référencées 13 à 20 sur la figure 3. Ainsi, le pas P13 correspond aux pas entre la limite 13 sur la piste Z et la limite 14 de la marque spécifique M1 ; le pas P14 représente le pas compris entre la limite 14 de la marque spécifique M1 et la limite 15 de la marque spécifique M2 ; P15 représente le pas entre la limite 15 de la marque spécifique M2 et la limite 16 de la marque spécifique M3 ; le pas P16 est le pas entre la limite 16 de la marque spécifique M3 et la limite 17 de la marque spécifique M2 ; le pas P17 est le pas réalisé par la limite 17 de la marque spécifique M2 et la limite 19 de la marque M1 ; le pas P18 est le pas réalisé par la limite 19 de la marque M1 et la limite 18 de la marque spécifique M3 ; et enfin, le pas P19 est réalisé par la limite 18 de fin de la marque spécifique M3 et la limite 20 de début d'une marque simple de la piste X.

En appliquant une technique binaire classique qui consiste à affecter la valeur binaire 2⁰ aux signaux du chronogramme X, la valeur 2¹ aux signaux du chronogramme Y et la valeur 2² aux signaux du chronogramme Z, on obtient, comme valeur de pas, les valeurs suivantes :
la valeur 0 pour le pas P13 ;
la valeur 1 pour le pas P14 ;
la valeur 3 pour le pas P15 ;
la valeur 7 pour le pas P16 ;
la valeur 5 pour le pas P17 ;
la valeur 4 pour le pas P18 ; et
la valeur 0 pour le pas P19.

On remarque que les pas P13 et P19 ont la même valeur puisque l'onde comprend six pas ; donc l'onde relative au TOP ZERO comprend les pas P13 à P18 ; le pas P19 est le premier pas de l'onde suivant l'onde relative au TOP ZERO.

D'une façon générale, on appelle "onde", l'ensemble répétitif des pas successifs. Dans cet exemple, l'onde de TOP ZERO comporte six pas : 0, 1, 3, 7, 5, 4. Cette onde doit exister au moins une fois par tour.

Le sens de rotation du mouvement est fourni par le système électronique décrit précédemment et qui tient compte de l'ordre des états successifs des pistes X et Y.

Sur la figure 3, on a également représenté les limites 21, 25, 26 et 27 de fin de marques simples et les limites 22, 23, 24 et 28 de début de marques simples.

Sur la figure 4, on a représenté les pas P21 à P27, réalisés par les limites de début et de fin de marques 21 à 28. De façon plus précise :
- le pas P21 est réalisé par la limite 21 de fin de marque de la piste Z et la limite 22 de début de marque de la piste X ;
- le pas P22 est réalisé par la limite 22 de début de marque de la piste X et la limite 23 de début de marque de la piste Y ;
- le pas P23 est compris entre la limite 23 de début de marque de la piste Y et la limite 24 de début de marque de la piste Z ;
- le pas P24 est compris entre la limite 24 de début de marque de la piste Z et la limite 25 de fin de marque de la piste X ;
- le pas P25 est compris entre la limite 25 de fin de marque de la piste X et la limite 26 de fin de marque de la piste Y ;
- le pas P26 est compris entre la limite 26 de fin de marque de la piste Y et la limite 27 de fin de marque de la piste Z ;
- le pas P27 est compris entre la limite 27 de fin de marque de la piste Z et la limite 28 de début de marque de la piste.

L'onde formée par les pas P21 à P26 est donc une onde dite "normale" puisque elle comprend des pas réalisés par des limites de marques de longueurs identiques, c'est-à-dire des limites de marques simples. Au contraire, l'onde réalisée par les pas P13 à P18 est une onde dite "modifiée", puisque c'est l'onde qui correspond au marquage spécifique du TOP ZERO de la règle de mesure R5.

En attribuant, selon la technique binaire classique, la valeur 2⁰ au chronogramme X, la valeur 2¹ au chronogramme Y et la valeur 2² au chronogramme Z, on obtient les valeurs de pas suivantes :

| Onde normale | Onde modifiée ou onde de TOP de référence |
|---|---|
| P21 a la valeur 0 | P13 a pour valeur 0 |
| P22 a la valeur 1 | P14 a pour valeur 1 |
| P23 a la valeur 3 | P15 a pour valeur 3 |
| P24 a la valeur 7 | P16 a pour valeur 7 |
| P25 a la valeur 6 | P17 a pour valeur 5 |
| P26 a la valeur 4 | P18 a pour valeur 4 |

On voit donc que l'onde normale et l'onde modifiée n'ont pas les mêmes valeurs de pas puisque le cinquième pas (pas P25) de l'onde normale a pour valeur 6 et le cinquième pas de l'onde modifiée (pas P17) a pour valeur 5. La détection de cette valeur 5 indique donc la position du TOP ZERO.

Ainsi, selon l'invention, après lecture de l'ensemble des pistes, on obtient des ondes successives identiques et: au moins une onde particulière correspondant au TOP de référence.

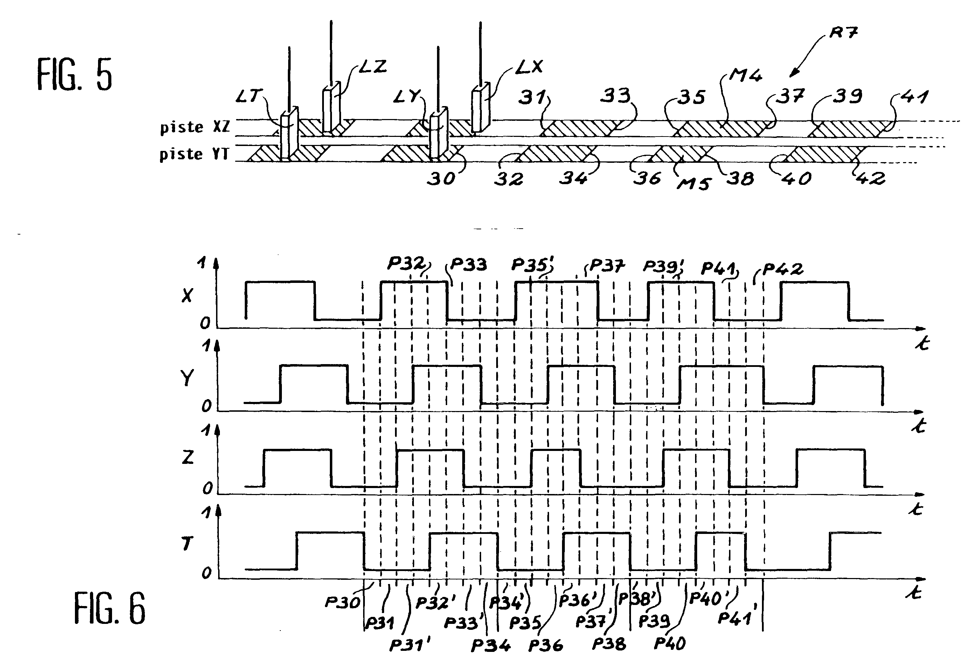

Sur la figure 5, on a représenté la structure d'un codeur à deux pistes selon un autre mode de réalisation de l'invention. La règle de mesure R7 de ce codeur comporte une première piste XZ à laquelle deux lecteurs LX et LZ sont associés et une seconde piste YT à laquelle deux lecteurs LT et LY sont associés.

A titre d'exemple, les lecteurs peuvent être positionnés entre eux de façon à avoir (N + 1/P).λ de distance entre LX et LZ, d'une part, et LY et LT, d'autre part, où N représente un nombre entier, P représente le nombre total de lecteurs et λ représente la longueur de l'onde définie par la règle de mesure. De plus, les lecteurs LX et LY, d'une part, et LZ et LT, d'autre part, sont décalés de (N + 1/2P).λ.

Pour l'exemple de la figure 5, on a choisi P = 4 et N = 1.

Pour ce mode de réalisation, le TOP ZERO est codé d'une façon sensiblement similaire à celle du codeur représenté sur la figure 5. Le TOP ZERO est donc codé par deux marques spécifiques M4 et M5, respectivement sur la piste XZ et la piste YT. Ces marques spécifiques M4 et M5 sont des marques ayant une longueur différente des marques simples, mais une largeur identique.

Comme sur les figures précédentes, on a référencé les limites de début et de fin de marques : les références 30, 33, 34, 41 et 42 représentent des limites de fin de marques sur les pistes XZ et YT ; et les références 31, 32, 39 et 40 représentent des limites de début de marques simples sur ces mêmes pistes ; la référence 35 représente la limite de début de la marque spécifique M4 et 36 représente la limite de début de la marque spécifique M5 ; la référence 37 représente la limite de fin de la marque spécifique M4 et la référence 38 est la limite de fin de la marque spécifique M5.

Sur la figure 6, on a représenté le diagramme temporel obtenu en sortie des conformateurs associés aux lecteurs LX, LZ, LY et LT. Le chronogramme X représente le signal logique obtenu en sortie du conformateur connecté au lecteur LX. Il en est, bien sûr, de même pour les chronogrammes Y, Z et T qui sont obtenus en sortie des conformateurs associés, respectivement, aux lecteurs LY, LZ et LT.

Sur cette figure 6, on a référencé par P30 à P42 les pas compris entre la limite de fin de marque 30 de la piste YT (sur la figure 7) et la limite de fin de marque 42 de cette même piste YT.

Si l'on regarde simultanément les figures 5 et 6, on comprend que les pas P30 à P34 constituent une onde normale, c'est-à-dire l'onde entre la limite de fin de marque 30 et la limite de fin de marque 34. Puisqu'il y a deux pistes et deux lecteurs par pistes, cette onde comporte huit pas. Si on associe, comme expliqué précédemment, les valeurs 2⁰ à X, 2¹ à Y, 2² à Z et 2³ à T, on obtient, pour cette onde normale, les valeurs des pas suivantes (calculées en hexadécimal) :
la valeur 0 pour le pas P30 ;
la valeur 1 pour le pas P31 ;
la valeur 5 pour le pas P31' ;
la valeur 7 pour le pas P32 ;
la valeur F pour le pas P32' ;
la valeur E pour le pas P33 ;
la valeur A pour le pas P33' ; et
la valeur 8 pour le pas P34.

Les huit pas suivant le pas P34, c'est-à-dire les pas P34' à P38, constituent une onde modifiée, à savoir l'onde de TOP ZERO. Cette onde est en effet comprise entre la limite 34 de fin de marque simple sur la piste YT et la limite 38 de fin de la marque spécifique M5 sur la piste YT.

On voit sur le chronogramme de X et sur le chronogramme de Y que les marques spécifiques M4 et M5 sont représentées, respectivement, par des signaux plus long et plus court que les signaux représentatifs des marques simples. Aussi, si l'on attribue à chaque chronogramme X, Y, Z et T les valeurs respectives 2⁰, 2¹, 2² et 2³, on obtient, en calculs hexadécimaux, les valeurs suivantes pour les pas P34' à P38 constituant l'onde de TOP ZERO :
le pas P34' a pour valeur 0 ;
le pas P35 a pour valeur 1 ;
le pas P35' a pour valeur 5 ;
le pas P36 a pour valeur 7 ;
le pas P36' a pour valeur F ;
le pas P37 a pour valeur B ;
le pas P37' a pour valeur A ;
le pas P38 a pour valeur 8.

On remarque, en regardant la figure 6, que le codage du TOP ZERO particularise, dans ce mode de réalisation, deux pas qui correspondent l'un au pas du TOP ZERO proprement dit et l'autre au pas d'un autre TOP, appelé TOP UN. L'onde suivant l'onde de TOP ZERO est donc appelée l'onde de TOP UN et comprend les pas P38' à P42.

Les chronogrammes Z et T comportent deux signaux représentatifs des marques spécifiques M4 et M5 ; ces signaux sont respectivement plus grands et plus petits que les signaux représentatifs des marques simples. On peut calculer sur cette figure 8, que la différence de pas entre le TOP ZERO et le TOP UN est de dix pas.

Si, comme précédemment, on affecte aux lignes X, Y, Z et T les valeurs 2⁰, 2¹, 2² et 2³, on obtient, pour cette onde, les valeurs des pas suivantes :
0 pour le pas P38' ;
1 pour le pas P39 ;
5 pour le pas P39' ;
7 pour le pas P40 ;
F pour le pas P40' ;
E pour le pas P41 ;
A pour le pas P41' ;
2 pour le pas P42.

En comparant les valeurs des pas de l'onde normale, de l'onde de TOP ZERO et de l'onde de TOP UN, on peut remarquer que :
. la valeur du sixième pas de l'onde normale est E tandis que la valeur du sixième pas de l'onde de TOP ZERO est B ; le pas de TOP ZERO est donc détecté grâce à cette différence de valeur de pas ;
. la valeur du huitième pas de l'onde normale est 8, tandis que la valeur du huitième pas de l'onde de TOP UN est 2 ; le pas de TOP UN est donc détecté grâce à cette différence de valeur de pas.

Un tel mode de réalisation permettant de détecter à la fois un TOP ZERO et un TOP UN a pour avantage de permettre un double calage du compteur de pas des moyens d'analyse, d'une part, sur une valeur 0, grâce au TOP ZERO et, d'autre part, sur une valeur 10, grâce au TOP UN. Une telle réalisation permet d'augmenter de façon importante la fiabilité du codeur.

Les modes de réalisation de l'invention qui viennent d'être décrits à travers les différentes figures ont l'avantage de présenter une densité d'informations sensiblement identique pour chacune des pistes du codeur. Par ailleurs, le codage ne présente plus de demi pas.

## Revendications

1. Codeur pour mesurer des mouvements relatifs entre un premier et un second objets comportant :
- une règle de mesure (R1, R3, R5, R7) portée par le premier objet et comprenant au moins deux pistes (X, Y) munies chacune d'une pluralité de marques ;
- au moins deux lecteurs de marques (LX, LY) portés par le second objet, chacune des pistes de la règle de mesure étant lue par au moins un lecteur de marques, celui-ci étant apte à détecter les marques de la piste à laquelle il est associé ; et
- des moyens de traitements (CX, CY, CL) connectés aux lecteurs de marques,
caractérisé en ce que toutes les pistes comportent sensiblement un même nombre de marques, en ce que chaque marque comprend une limite (14, 15, 16,...) de début et une limite (17, 18, 19,...) de fin de marque qui définissent chacune un changement de pas (P14, P15,...) sur la règle de mesure et en ce que les marques de la règle de mesure consistent en une pluralité de marques simples ayant toutes des caractéristiques sensiblement identiques et au moins deux marques spécifiques (MO - M5) située, respectivement, sur deux pistes distinctes de la règle de mesure pour indiquer au moins une position de référence de la règle et ayant chacune au moins une caractéristique qui diffère des caractéristiques des marques simples, les marques spécifiques ayant une longueur, dans le sens du déplacement, supérieure ou inférieure à celle des marques simples, ladite longueur correspondant à la caractéristique qui diffère l'ensemble des marques simples et des marques spécifiques de toutes les pistes définissant une succession de pas réguliers le long de la règle.

2. Codeur selon la revendication 1, caractérisé en ce que la règle de mesure comporte une marque spécifique sur chaque piste, chacune de ces marques spécifiques ayant une longueur différente à la fois des marques simples et des autres marques spécifiques.

3. Codeur selon l'une quelconque des revendications 1 et 2, caractérisé en ce que la marque spécifique a une largeur sensiblement inférieure ou supérieure à celle des marques simples.

4. Codeur selon l'une quelconque des revendications 1 à 3, caractérisé en ce que la caractéristique qui diffère entre les marques simples et la marque spécifique est la densité optique de marquage.

5. Codeur selon l'une quelconque des revendications 1 à 4, caractérisé en ce que les moyens de traitements comportent, pour chaque lecteur, un amplificateur (AX, AY,...) et au moins un conformateur (CX, CY,...) pour transformer le signal de sortie du lecteur en un signal numérique et des moyens d'analyse (CL) des signaux numériques issus des conformateurs.

## Patentansprüche

1. Kodierer zum Messen der Relativbewegungen zwischen einem ersten und einem zweiten Objekt, umfassend:
- einen Maßstab (R1, R3, R5, R7) auf dem ersten Objekt, der wenigstens zwei Spuren (X, Y) umfasst, die eine Vielzahl Markierungen aufweisen;
- wenigsten zwei Markierungsleser (LX, LY) auf dem zweiten Objekt, wobei jede der Spuren des Maßstabs durch wenigstens einen Markierungsleser gelesen wird und dieser dabei fähig ist, die Markierungen der Spur zu erkennen, der er zugeordnet ist; und
- Verarbeitungseinrichtungen (CX, CY, CL), die mit den Markierungslesern verbunden sind,
**dadurch gekennzeichnet,**
dass alle Spuren im Wesentlichen dieselbe Anzahl Markierungen aufweisen, dass jede Markierung eine Markierungsanfangsgrenze (14, 15, 16, ...) und eine Markierungsendgrenze (17, 18, 19, ...) umfasst, von denen jede einen Teilungswechsel (P14, P15, ...) auf dem Maßstab definiert, und dadurch, dass die Markierungen des Maßstabs durch eine Vielzahl einfacher Markierungen, die alle im Wesentlichen identische Charakteristika aufweisen, und wenigstens zwei spezifische Markierungen (M0 - M5) gebildet werden, die sich jeweils auf zwei verschiedenen Spuren des Maßstabs befinden, um wenigstens eine Bezugsposition des Maßstabs anzugeben, und von denen jede wenigstens eine Charakteristik aufweist, die sich von den Charakteristika der einfachen Markierungen unterscheidet, wobei diese spezifischen Markierungen in der Verschiebungsrichtung eine Länge haben, die größer oder kleiner als die der einfachen Markierungen ist, und diese Länge dabei der Charakteristik entspricht, die die Gesamtheit der einfachen Markierungen und der spezifischen Markierungen aller Spuren unterscheidet und eine Folge gleichmäßiger Teilungen längs des Maßstabs definiert.

2. Kodierer nach Anspruch 1, dadurch gekennzeichnet, dass der Maßstab eine spezifische Markierung in jeder Spur umfasst, wobei jede dieser spezifischen Markierungen eine Länge aufweist, die sich zugleich von der der einfachen Markierungen und der der anderen, spezifischen Markierungen unterscheidet.

3. Kodierer nach einem der Ansprüche 1 und 2, dadurch gekennzeichnet, dass die spezifische Markierung eine Länge aufweist, die im Wesentlichen kleiner oder größere als die der einfachen Markierungen ist.

4. Kodierer nach einem der Ansprüche 1 bis 3, dadurch gekennzeichnet, dass die den Unterschied zwischen den einfachen Markierungen und den spezifischen Markierungen bildende Charakteristik die optische Markierungsdichte ist.

5. Kodierer nach einem der Ansprüche 1 bis 4, dadurch gekennzeichnet, dass die Verarbeitungseinrichtungen für jeden Leser einen Verstärker (AX, AY,...) und, um das Ausgangssignal des Lesers in ein digitales Signal umzuwandeln, wenigstens einen Impulsformer (CX, CY,...) sowie Analyseeinrichtungen (CL) der durch den Impulsformer erzeugten digitalen Signale umfassen.

## Claims

1. Coder for measuring relative movements between a first and a second objects comprising:
- a measuring rule (R1, R3, R5, R7) carried by the first object and having at least two tracks (X, Y), each provided with a plurality of marks,
- at least two mark readers (LX, LY) carried by the second object, each of the tracks of the measuring rule being read by at least one mark reader, the latter being able to detect the marks of the track with which it is associated and
- processing means (CX, CY, CL) connected to the mark readers,
characterized in that all the tracks have substantially the same number of marks, that each mark has a start limit (14, 15, 16) and an end limit (17, 18, 19), each of which defines a spacing change (P14, P15) on the measuring rule and that the marks of the measuring rule consist of a plurality of simple marks all of which have substantially identical characteristics and at least two specific marks (MO-M5) respectively located on two distinct tracks of the measuring rule for indicating at least a reference position of the rule and each having at least one characteristic differing from the characteristics of the simple marks, the specific marks having a length, in the displacement direction, greater than or less than that of the simple marks, the said length corresponding to the characteristic which makes different the set of simple marks and specific marks from all the tracks defining a succession of regular spacings along the rule.

2. Coder according to claim 1, characterized in that the measuring rule has a specific mark on each track, each of the said specific marks having a length different both from the simple marks and the other specific marks.

3. Coder according to either of the claims 1 and 2, characterized in that the specific mark has a length significantly greater or less than that of the simple marks.

4. Coder according to any one of the claims 1 to 3, characterized in that the characteristic differentiating the simple marks and the specific mark is the optical marking density.

5. Coder according to any one of the claims 1 to 4, characterized in that the processing means comprise, for each reader, an amplifier (AX, AY) and at least one former (CX, CY) for transforming the output signal of the reader into a digital signal and means (CL) for analyzing the digital signals from the formers.
